# EUROPEAN PATENT APPLICATION

(11) **EP 4 528 821 A1**
(43) Date of publication of application: **26.03.2025**
(21) Application number: 24157090.2
(22) Date of filing: 12.02.2024
(51) Int. Cl.: H01L 29/739, H01L 29/861, H01L 29/32, H01L 21/331, H01L 29/08, H01L 29/40

(54) **MANUFACTURING METHOD OF SEMICONDUCTOR DEVICE AND SEMICONDUCTOR DEVICE**

(30) Priority: 22.09.2023 JP 2023158959
(71) Applicant: Kabushiki Kaisha Toshiba, Tokyo 105-0023 (JP); Toshiba Electronic Devices & Storage Corporation, Tokyo 105-0023 (JP)
(72) Inventor: HYODO, Ko, Tokyo (JP); YOSHIKAWA, Daiki, Tokyo (JP)
(74) Representative: Kramer Barske Schmidtchen Patentanwälte PartG mbB

(57) **Abstract**

A manufacturing method of a semiconductor device according to an embodiment includes: forming a semiconductor portion including a transistor region and a diode region; forming a first lifetime control region in a lower portion of the semiconductor portion in the diode region, with ion irradiated from an upper side of the semiconductor portion; and forming a second lifetime control region in an upper portion of the semiconductor portion, with ion irradiated through a mask from the upper side of the semiconductor portion, the second lifetime control region being formed simultaneously with the first lifetime control region so as not to overlap with the first lifetime control region.

## Description

### FIELD

An embodiment of the present invention relates to a manufacturing method of a semiconductor device, and a semiconductor device.

### BACKGROUND

As a semiconductor device, an RC (Reverse Conductive)-IGBT (Insulated Gate Bipolar Transistor) has been known. In the RC-IGBT, a transistor region where an IGBT is provided and a diode region where an FWD (Free Wheeling Diode) connected inversely parallel to the IGBT is provided are formed on the same substrate. In other words, the IGBT and the FWD are formed on one semiconductor chip.

The semiconductor device as described above has a technical problem in that the recovery loss deteriorates due to the tail current of accumulated carriers in the diode region at the time of recovery operation of the FWD and the operation of the parasitic diode inducing injection of holes from the transistor region to the diode region at the time of on-operation of the FWD.

Thus, for solving the aforementioned technical problem, a technique has been known in which a lifetime control region is provided by producing lattice defects with ion with which the transistor region and the diode region are irradiated.

### BRIEF DESCRIPTION OF THE DRAWINGS

FIG. 1 is a cross-sectional view of a semiconductor device according to a first embodiment that is cut in a vertical direction.
FIG. 2 is a view showing a flow of processes before and after a lifetime control region forming process of the semiconductor device according to the first embodiment.
FIG. 3 is a cross-sectional view for explaining a front surface element structure forming process.
FIG. 4 is a cross-sectional view for explaining a resist pattern forming process.
FIG. 5 is a cross-sectional view for explaining a metal mask attaching process.
FIG. 6 is a cross-sectional view for explaining an ion irradiation process.
FIG. 7 is a cross-sectional view for explaining a back surface grinding process.
FIG. 8 is a cross-sectional view for explaining a back surface diffusion layer forming process.
FIG. 9 is a cross-sectional view for explaining a first electrode process.
FIG. 10 is a cross-sectional view of a semiconductor device according to a comparative example that is cut in a vertical direction.
FIG. 11 is a cross-sectional view for explaining a first metal mask attaching process and a first ion irradiation process.
FIG. 12 is a cross-sectional view for explaining a second metal mask attaching process and a second ion irradiation process.
FIG. 13 is a cross-sectional view of a semiconductor device according to a second embodiment that is cut in a vertical direction.

### DETAILED DESCRIPTION

Embodiments will now be explained with reference to the accompanying drawings. The present invention is not limited to the embodiments.

A manufacturing method of a semiconductor device according to an embodiment includes: forming a semiconductor portion including a transistor region and a diode region; forming a first lifetime control region in a lower portion of the semiconductor portion in the diode region, with ion irradiated from an upper side of the semiconductor portion; and forming a second lifetime control region in an upper portion of the semiconductor portion, with ion irradiated through a mask from the upper side of the semiconductor portion, the second lifetime control region being formed simultaneously with the first lifetime control region so as not to overlap with the first lifetime control region.

### (First embodiment)

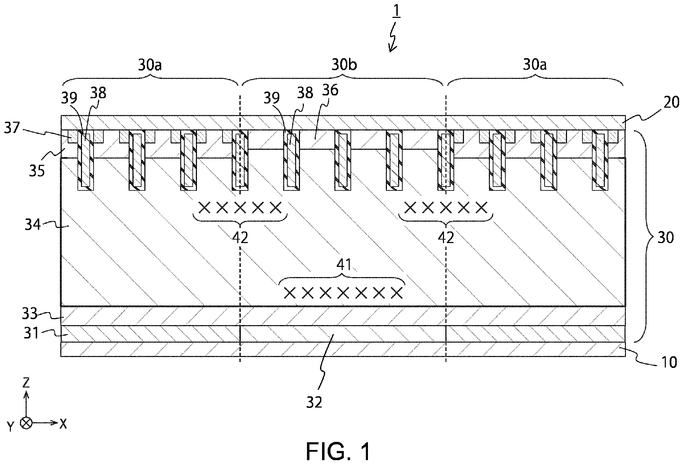

FIG. 1 is a cross-sectional view of a semiconductor device according to a first embodiment that is cut in a vertical direction. In the following description, in some cases, the arrangement and configuration of each portion of the semiconductor device are described using an X-axis, a Y-axis, and a Z-axis shown in each drawing. The X-axis, the Y-axis, and the Z-axis are orthogonal to one another, respectively indicating an X-direction, a Y-direction, and a Z-direction. Further, some descriptions are made assuming the Z-direction as the upper side and the opposite direction as the lower side. In the present embodiment, the X-direction and the Y-direction respectively correspond to a second direction and a third direction, and indicate an in-plane direction parallel to a front surface (or back surface) of a semiconductor device 1. The Z-direction corresponds to a first direction, and indicates an out-of-plane direction orthogonal to the front surface (or back surface) of the semiconductor device 1.

Further, notations of p, p⁺ mean that the concentration of a p-type impurity increases in this order. In addition, notations of n⁻, n, n⁺ mean that the concentration of an n-type impurity increases in this order.

The impurity concentration can be measured by, for example, the SIMS (Secondary Ion Mass Spectrometry). Further, the relative level of the impurity concentration can also be determined from, for example, the level of the concentration of carriers obtained by the SCM (Scanning Capacitance Microscopy). In addition, a distance such as a depth of the semiconductor region can be obtained by, for example, the SIMS.

The semiconductor device 1 shown in FIG. 1 is an RC-IGBT. The semiconductor device 1 includes a first electrode 10, a second electrode 20, and a semiconductor portion 30. Further, the semiconductor portion 30 includes a transistor region 30a provided with a transistor element such as an IGBT and a diode region 30b provided with a diode element such as an FWD. The transistor region 30a and the diode region 30b are alternately arranged along the X-direction. Note that an isolation region that is not provided with either the transistor element or the diode element may be provided between the transistor region 30a and the diode region 30b.

The first electrode 10 is provided on the back surface of the semiconductor portion 30. The first electrode 10 can be formed by, for example, using metal such as aluminum. The first electrode 10 functions as a collector electrode in the transistor region 30a and functions as a cathode electrode in the diode region 30b.

The second electrode 20 faces the first electrode across the semiconductor portion 30 in the Z-direction. The second electrode 20 can be formed by, for example, using metal such as aluminum. The second electrode 20 functions as an emitter electrode in the transistor region 30a and functions as an anode electrode in the diode region 30b.

The semiconductor portion 30 includes a p⁺ collector region 31, an n⁺ cathode region 32, an n buffer region 33, an n⁻ base region 34, a p base region 35, a p anode region 36, an n⁺ emitter region 37, a gate electrode 38, and a gate insulating film 39. The p⁺ collector region 31 corresponds to a p-type third semiconductor region. The n⁺ cathode region 32 corresponds to an n-type fourth semiconductor region. The n buffer region 33 corresponds to an n-type second semiconductor region. The n⁻ base region 34 corresponds to an n-type first semiconductor region.

The p⁺ collector region 31 is provided on the first electrode 10 in the transistor region 30a. The n⁺ cathode region 32 is provided on the first electrode 10 in the diode region 30b. In the present embodiment, the thickness of the n⁺ cathode region 32 is substantially the same as the thickness of the p⁺ collector region 31. That is, the n⁺ cathode region 32 and the p⁺ collector region 31 are formed in a layer where the depth from a front surface of the semiconductor portion 30 is the same as each other. However, the thickness of the n⁺ cathode region 32 and the thickness of the p⁺ collector region 31 need not necessarily be the same, and may be different from each other.

The n buffer region 33 is provided on the p⁺ collector region 31 and the n⁺ cathode region 32. On the n buffer region 33, the n⁻ base region 34 is provided.

The n⁻ base region 34 is provided with a first lifetime control region 41 and a second lifetime control region 42. In each of the first lifetime control region 41 and the second lifetime control region 42, lattice defects functioning as a lifetime killer are formed.

The first lifetime control region 41 is provided in a lower portion, in other words, a boundary portion with the n buffer region 33, of the n⁻ base region 34. Meanwhile, the second lifetime control region 42 is provided in an upper portion, which is a boundary portion between the transistor region 30a and the diode region 30b, of the n⁻ base region 34.

The first lifetime control region 41 and the second lifetime control region 42 are formed through irradiation of a hydrogen ion, a helium ion, or the like. At this time, in order to simultaneously form the first lifetime control region 41 and the second lifetime control region 42, these two lifetime control regions are formed so as not to overlap with each other in the Z-direction. In other words, the first lifetime control region 41 and the second lifetime control region 42 are formed so as to be displaced with respect to each other in the X-direction.

On the n⁻ base region 34 positioned in the transistor region 30a, the p base region 35 is provided. Further, on the n⁻ base region 34 positioned in the diode region 30b, the p anode region 36 is provided. In the present embodiment, the concentration of the p-type impurity contained in the p base region 35 is the same as the concentration of the p-type impurity contained in the p anode region 36. However, the concentrations of the p-type impurity of the p base region 35 and the p anode region 36 need not necessarily be the same, and may be different from each other. The p base region 35 and the p anode region 36 having different concentrations of the p-type impurity can be formed by, for example, separately implanting ion.

Note that in the present embodiment, the thickness of the p base region 35 is greater than the thickness of the p anode region 36. In other words, the p base region 35 is formed up to a deeper position from the front surface of the semiconductor portion 30 than the p anode region 36. However, the thickness of the p base region 35 need not necessarily be greater than the thickness of the p anode region 36 and may be the same as or smaller than the thickness of the p anode region 36.

The n⁺ emitter region 37 contacts the p base region 35. The n⁺ emitter region 37 contacts the second electrode 20. When a voltage between the gate electrode 38 and the second electrode 20 (emitter electrode) is equal to or greater than a threshold voltage, an n channel is formed in the p base region 35. In this manner, in the transistor region 30a, a current path leading to the n⁺ emitter region 37 from the p⁺ collector region 31 via the n channel is formed.

The gate electrode 38 faces the p base region 35 and the n⁺ emitter region 37 via the gate insulating film 39. The gate electrode 38 can be formed by, for example, using polysilicon. Further, the gate insulating film 39 is, for example, a silicon oxide (SiO₂) film.

Note that in the present embodiment, the gate electrode 38 and the gate insulating film 39 are provided not only in the transistor region 30a, but also in the diode region 30b. However, the diode region 30b is not provided with the n⁺ emitter region 37. Therefore, the gate electrode 38 provided in the diode region 30b is a dummy gate electrode.

In the semiconductor device 1, at the time of recovery operation of the FWD, when the tail current of the accumulated carriers in the diode region 30b is large, the recovery loss of the FWD increases. Thus, in the present embodiment, the first lifetime control region 41 is formed in the lower portion of the n⁻ base region 34 in the diode region 30b. Since the lattice defects as the lifetime killer are formed in the first lifetime control region 41, the tail current can be reduced. As a result, the recovery loss can be reduced.

Further, in the semiconductor device 1, when the p base region 35 in the transistor region 30a and the n⁺ cathode region 32 in the diode region 30b operate as a parasitic diode at the time of on-operation of the FWD, holes are injected from the transistor region 30a to the diode region 30b. As a result, the recovery loss of the FWD could deteriorate. Thus, in the present embodiment, the second lifetime control region 42 is formed in an upper portion of the n⁻ base region 34 in a boundary portion between the transistor region 30a and the diode region 30b. Since the lattice defects as the lifetime killer are also formed in the second lifetime control region 42, the operation of the parasitic diode can be controlled. In this manner, the recovery loss can be reduced. Note that when the second lifetime control region 42 is formed on a front surface of the transistor region 30a, the on-state characteristics of the IGBT could deteriorate. In addition, due to damage to the gate insulating film 39 at the time of forming the second lifetime control region 42, the gate threshold voltage (Vth) could fluctuate. Thus, in the present embodiment, the region where the second lifetime control region 42 is formed is limited to the front surface in the boundary portion between the transistor region 30a and the diode region 30b. In this manner, while suppressing the disadvantages such as deterioration of the on-state characteristics of the IGBT and the fluctuation of the gate threshold voltage (Vth), the operation of the parasitic diode can be suppressed.

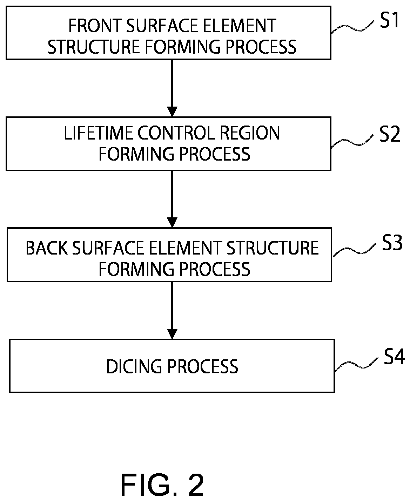

Here, with reference to FIG. 2 to FIG. 9, a manufacturing method of the semiconductor device 1 according to the present embodiment will be described. Herein, a lifetime control region forming process of forming the first lifetime control region 41 and the second lifetime control region 42 and manufacturing processes before and after the lifetime control region forming process will be mainly described.

FIG. 2 is a view showing a flow of processes before and after the lifetime control region forming process of the semiconductor device 1 according to the present embodiment. As shown in FIG. 2, before the lifetime control region forming process (step S2), a front surface element structure forming process (step S1) takes place. Further, after the lifetime control region forming process, a back surface element structure forming process (step S3) takes place. Furthermore, after the back surface element structure forming process (step S3), a dicing process (step S4) takes place.

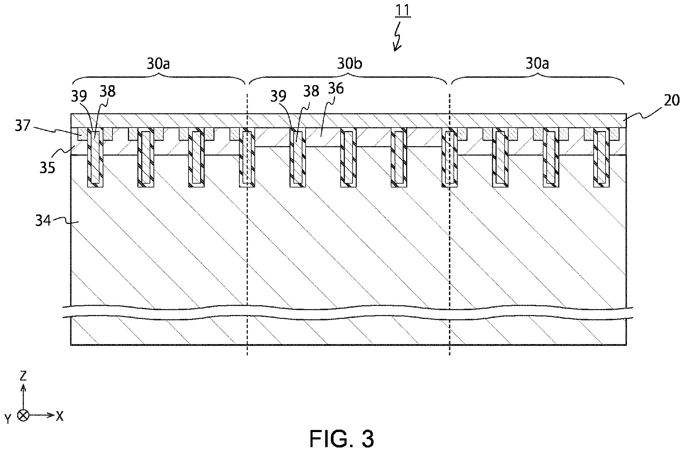

FIG. 3 is a cross-sectional view for explaining the front surface element structure forming process. In the front surface element structure forming process, first, the n⁻ base region 34 is formed on a semiconductor wafer 11.

Subsequently, in the transistor region 30a, the p base region 35, the n⁺ emitter region 37, the gate electrode 38, and the gate insulating film 39 are sequentially formed on the n⁻ base region 34. Meanwhile, in the diode region 30b, the p anode region 36, the gate electrode 38, and the gate insulating film 39 are sequentially formed on the n⁻ base region 34. However, the gate electrode 38 formed in the diode region 30b is a dummy gate electrode.

Finally, the second electrode 20 is formed. The p base region 35 to the gate insulating film 39, and the second electrode 20 can be formed using manufacturing methods typically used, and thus, the detailed description will be omitted.

Next, the lifetime control region forming process will be described. The lifetime control region forming process includes a resist pattern forming process, a metal mask attaching process, and an ion irradiation process.

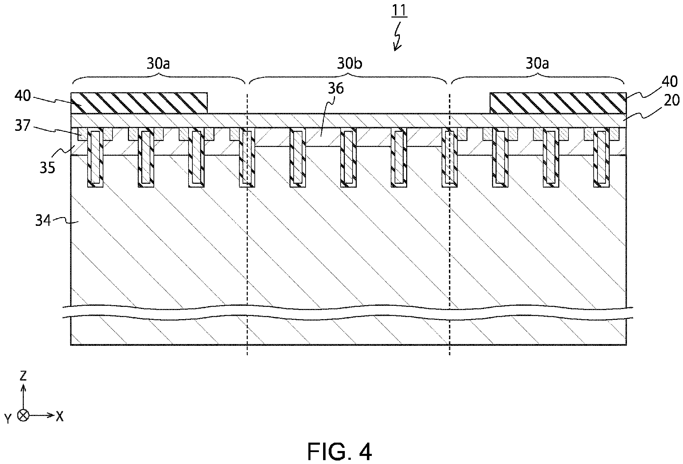

FIG. 4 is a cross-sectional view for explaining the resist pattern forming process. In the resist pattern forming process, first, a resist 40 is applied on an entire upper surface of the second electrode 20. Subsequently, the resist 40 applied on a region facing the boundary portion between the transistor region 30a and the diode region 30b and the resist 40 applied on a region facing the diode region 30b of the upper surface of the second electrode 20 are removed by exposure and development. As a result, as shown in FIG. 4, a pattern of the resist 40 is formed such that the region facing the boundary portion between the transistor region 30a and the diode region 30b and the region facing the diode region 30b are exposed.

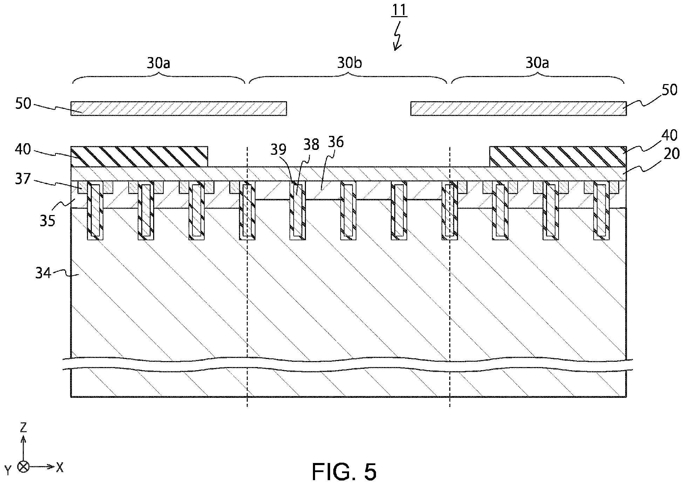

FIG. 5 is a cross-sectional view for explaining the metal mask attaching process. In the metal mask attaching process, a metal mask 50 is disposed above the resist 40. The metal mask 50 contains, for example, aluminum or nickel.

The metal mask 50 is patterned so as to expose a portion where the first lifetime control region 41 is formed while shielding a portion where the second lifetime control region 42 is formed. Further, the thickness of the metal mask 50 is designed to be a value that allows ion irradiated in the subsequent ion irradiation process to remain in the portion where the second lifetime control region 42 is formed.

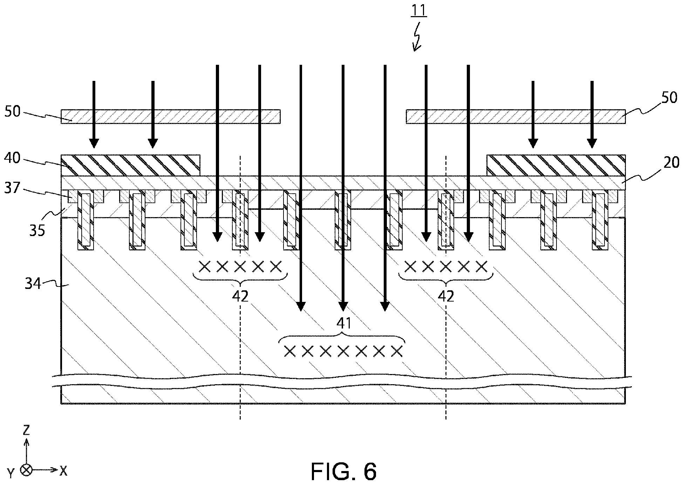

FIG. 6 is a cross-sectional view for explaining the ion irradiation process. In the ion irradiation process, ion containing hydrogen or helium is irradiated toward the n⁻ base region 34 from an upper side of the metal mask 50. At this time, in the exposed portion that is not shielded by the metal mask 50 in the n⁻ base region 34, the irradiated ion reaches a position at a predetermined depth in the n⁻ base region 34. As a result, the first lifetime control region 41 is formed.

Further, in the portion shielded only by the metal mask 50 in the n⁻ base region 34, that is, the boundary portion between the transistor region 30a and the diode region 30b, the irradiated ion reaches the upper portion of the n⁻ base region 34. As a result, the second lifetime control region 42 is formed simultaneously with the first lifetime control region 41.

Note that the irradiated ion does not reach the region shielded by both the resist 40 and the metal mask 50 of the n⁻ base region 34. Further, after the ion irradiation process, the resist 40 is stripped. In this manner, the lifetime control region forming process is completed.

Next, the back surface element structure forming process will be described. The back surface element structure forming process includes a back surface grinding process, a back surface diffusion layer forming process, and a first electrode process.

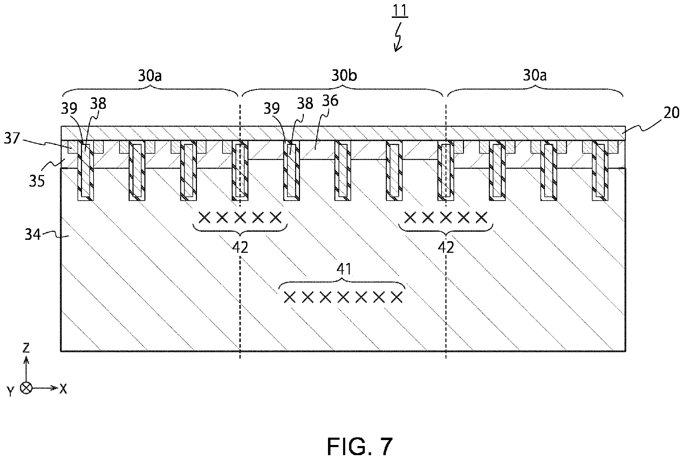

FIG. 7 is a cross-sectional view for explaining the back surface grinding process. In the back surface grinding process, the n⁻base region 34 is ground from its back surface side. As a result, the first lifetime control region 41 is positioned in the lower portion of the n⁻ base region 34.

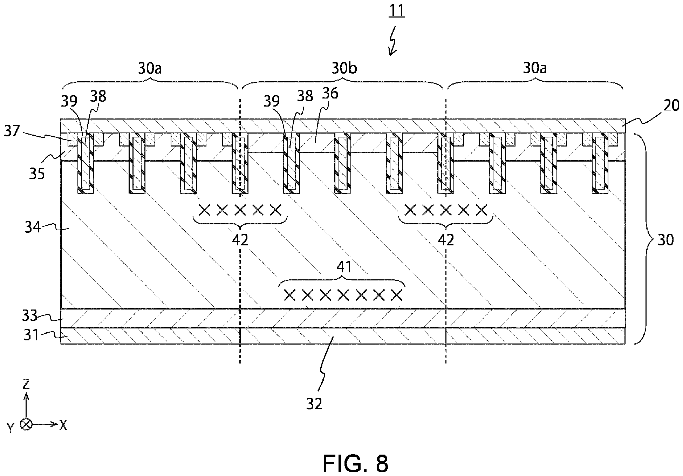

FIG. 8 is a cross-sectional view for explaining the back surface diffusion layer forming process. In the back surface diffusion layer forming process, the n buffer region 33 is formed below the n⁻ base region 34. Subsequently, in the transistor region 30a, the p⁺ collector region 31 is formed below the n buffer region 33. Meanwhile, in the diode region 30b, the n⁺ cathode region 32 is formed below the n buffer region 33. The p⁺ collector region 31, the n⁺ cathode region 32, and the n buffer region 33 can be formed using manufacturing methods typically used, and thus, the detailed description will be omitted.

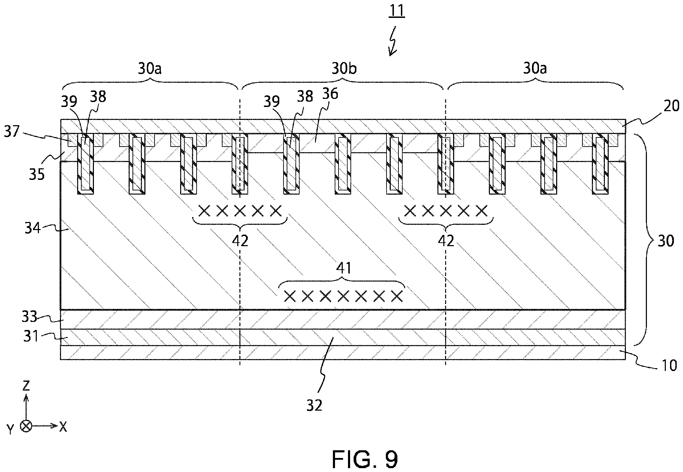

FIG. 9 is a cross-sectional view for explaining the first electrode process. In the first electrode process, the first electrode 10 is formed below the p⁺ collector region 31 and the n⁺ cathode region 32. In this manner, the back surface element structure forming process is completed.

In the final dicing process, the semiconductor wafer 11 shown in FIG. 9 is cut in a lattice form using a blade. As a result, the semiconductor wafer 11 is divided into a plurality of semiconductor chips.

Here, a comparative example that is compared with the present embodiment will be described.

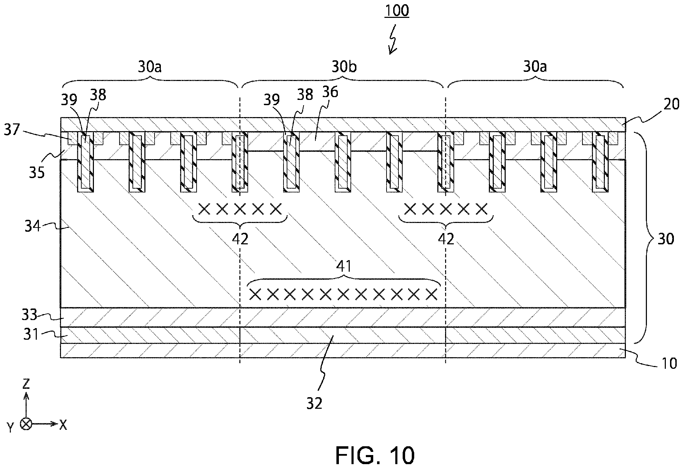

FIG. 10 is a cross-sectional view of a semiconductor device according to the comparative example that is cut in a vertical direction. In FIG. 10, the same constituent elements as those of the aforementioned semiconductor device 1 are assigned the same reference signs and the overlapping description will be omitted.

In a semiconductor device 100 according to the present comparative example, as shown in FIG. 10, the first lifetime control region 41 and the second lifetime control region 42 overlap with each other in the Z-direction. Therefore, the first lifetime control region 41 and the second lifetime control region 42 of the comparative example cannot be simultaneously formed. Hereinafter, the lifetime control region forming process according to the comparative example will be described.

The lifetime control region forming process according to the comparative example includes a first metal mask attaching process, a first ion irradiation process, a second metal mask attaching process, and a second ion irradiation process.

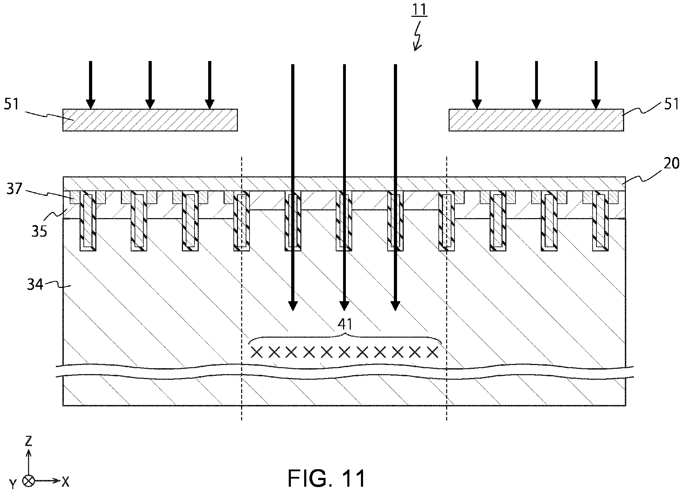

FIG. 11 is a cross-sectional view for explaining the first metal mask attaching process and the first ion irradiation process.

In the first metal mask attaching process, a first metal mask 51 is disposed above the second electrode 20. The first metal mask 51 exposes the diode region 30b while shielding the transistor region 30a. Further, the thickness of the first metal mask 51 is designed to be a value that does not allow the ion irradiated in the subsequent first ion irradiation process to pass through.

In the first ion irradiation process, ion containing hydrogen or helium is irradiated toward the n⁻ base region 34 from an upper side of the first metal mask 51. At this time, in an exposed portion that is not shielded by the metal mask 51 in the n⁻ base region 34, that is, in the diode region 30b, the irradiated ion reaches a position at a predetermined depth in the n⁻ base region 34. As a result, the first lifetime control region 41 according to the comparative example is formed.

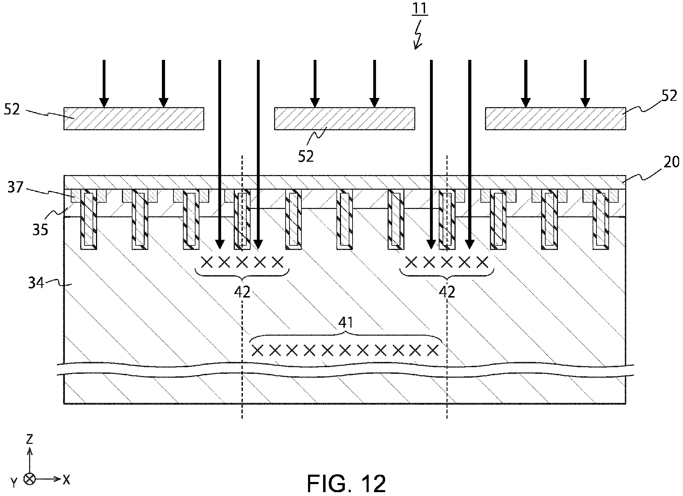

FIG. 12 is a cross-sectional view for explaining the second metal mask attaching process and the second ion irradiation process.

In the second metal mask attaching process, a second metal mask 52 is disposed above the second electrode 20. The second metal mask 52 shields a portion excluding the boundary portion between the transistor region 30a and the diode region 30b. Further, the thickness of the second metal mask 52 is designed to be a value that does not allow the ion irradiated in the subsequent second ion irradiation process to pass through.

In the second ion irradiation process, ion containing hydrogen or helium is irradiated toward the n⁻ base region 34 from an upper side of the second metal mask 52. At this time, the ion is irradiated so as to reach an exposed portion that is not shielded by the second metal mask 52 in the n⁻ base region 34, that is, an upper portion of the boundary portion between the transistor region 30a and the diode region 30b. As a result, the second lifetime control region 42 according to the comparative example is formed.

In the lifetime control region forming process according to the present comparative example, two metal masks of the first metal mask 51 and the second metal mask 52 and two ion irradiation processes of the first ion irradiation process and the second ion irradiation process are required. Therefore, it takes much time to form the first lifetime control region 41 and the second lifetime control region 42. As a result, the process cost increases.

By contrast, in the present embodiment, the metal mask 50, which is made thinner to allow the ion to pass through so that the shielding capability is intentionally reduced, and the resist 40 are concurrently used. Thus, with one sheet of the metal mask 50 and the ion irradiation performed once, the first lifetime control region 41 and the second lifetime control region 42 can be simultaneously formed. Thus, the time for the lifetime control region forming process can be reduced and as a result, the process cost can be reduced.

### (Second embodiment)

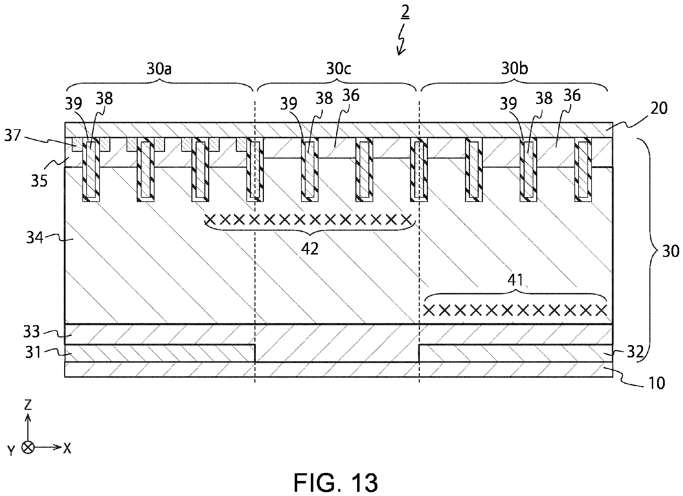

FIG. 13 is a cross-sectional view of a semiconductor device according to a second embodiment that is cut in a vertical direction. In FIG. 13, the same constituent elements as those of the aforementioned semiconductor device 1 according to the first embodiment are assigned the same reference signs and the overlapping description will be omitted.

In the semiconductor portion 30 of a semiconductor device 2 shown in FIG. 13, an isolation region 30c is provided between the transistor region 30a and the diode region 30b. In the isolation region 30c, the n buffer region 33, the n⁻ base region 34, and the p anode region 36 are stacked in this order between the first electrode 10 and the second electrode 20.

Further, in the n⁻ base region 34 and the p anode region 36 in the isolation region 30c, the gate electrode 38 and the gate insulating film 39 are provided. However, this gate electrode 38 is a dummy gate electrode as with the gate electrode 38 provided in the diode region 30b.

In addition, in the semiconductor device 2 according to the present embodiment, the first lifetime control region 41 is provided in a lower portion of the n⁻ base region 34 in the diode region 30b. With this first lifetime control region 41, the tail current of the accumulated carriers in the diode region 30b at the time of recovery operation of the FWD can be reduced.

Meanwhile, the second lifetime control region 42 is provided from the upper portion of the n⁻ base region 34 in the isolation region 30c to the upper portion of the n⁻ base region 34 in a boundary portion between the isolation region 30c and the transistor region 30a. With this second lifetime control region 42, the operation of the parasitic diode at the time of on-operation of the FWD can be suppressed.

In the present embodiment also, similar to the first embodiment, the first lifetime control region 41 and the second lifetime control region 42 are arranged so as to be displaced with respect to each other in the X-direction, and thus, do not overlap with each other in the Z-direction. Therefore, similar to the first embodiment, by concurrently using the metal mask 50 and the resist 40, with one sheet of the metal mask 50 and the ion irradiation performed once, the first lifetime control region 41 and the second lifetime control region 42 can be simultaneously formed.

Therefore, according to the present embodiment, the time for the lifetime control region forming process can be reduced and as a result, the process cost can be reduced.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.
It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A manufacturing method of a semiconductor device, the method comprising:
forming a semiconductor portion (30) including a transistor region (30a) and a diode region (30b);
forming a first lifetime control region (41) in a lower portion of the semiconductor portion (30) in the diode region (30b), with ion irradiated from an upper side of the semiconductor portion (30); and
forming a second lifetime control region (42) in an upper portion of the semiconductor portion (30), with ion irradiated through a mask (50) from the upper side of the semiconductor portion (30), the second lifetime control region (42) being formed simultaneously with the first lifetime control region (41) so as not to overlap with the first lifetime control region (41).

2. The manufacturing method according to claim 1, the method comprising forming the second lifetime control region (42) in an upper portion of a boundary portion between the transistor region (30a) and the diode region (30b).

3. The manufacturing method according to claim 1, the method comprising:
forming an isolation region (30c) between the transistor region (30a) and the diode region (30b); and
forming the second lifetime control region (42) in an upper portion of a boundary portion between the transistor region (30a) and the isolation region (30c).

4. The manufacturing method according to any one of claims 1 to 3, the method comprising forming the first lifetime control region (41) and the second lifetime control region (42), with a resist (40) disposed between the transistor region (30a) and the mask (50), the resist (40) not allowing the ion to pass through.

5. The manufacturing method according to any one of claims 1 to 4, wherein the mask (50) is a metal mask containing aluminum or nickel.

6. The manufacturing method according to any one of claims 1 to 5, wherein the ion is a hydrogen ion or a helium ion.

7. The manufacturing method according to any one of claims 1 to 6, the method comprising forming the first lifetime control region (41) and the second lifetime control region (42) in an n-type first semiconductor region (34)of the semiconductor portion (30).

8. The manufacturing method according to claim 7, the method comprising:
forming an n-type second semiconductor region (33) below the first semiconductor region (34) after forming the first lifetime control region (41) and the second lifetime control region (42);
forming a p-type third semiconductor region (31) below the second semiconductor region (33) in the transistor region (30a);
forming an n-type fourth semiconductor region (32) below the second semiconductor region (33) in the diode region (30b); and
forming a first electrode (10) below the third semiconductor region (31) and the fourth semiconductor region (32).

9. The manufacturing method according to claim 8, the method comprising forming the first lifetime control region (41) and the second lifetime control region (42), with a second electrode (20) formed on the semiconductor portion (30).

10. The manufacturing method according to any one of claims 1 to 9, the method comprising:
forming an IGBT (Insulated Gate Bipolar Transistor) in the transistor region (30a); and
forming an FWD (Free Wheeling Diode) in the diode region (30b).

11. A semiconductor device comprising:
a first electrode (10);
a second electrode (20) facing the first electrode (10) in a first direction;
a semiconductor portion (30) provided between the first electrode (10) and the second electrode (20), the semiconductor portion (30) including a transistor region (30a) and a diode region (30b);
a first lifetime control region (41) provided in a lower portion of the diode region (30b); and
a second lifetime control region (42) that is provided in an upper portion of the semiconductor portion (30) so as not to overlap with the first lifetime control region (41) in the first direction.

12. The semiconductor device according to claim 11, wherein the second lifetime control region (42) is provided in an upper portion of a boundary portion between the transistor region (30a) and the diode region (30b).

13. The semiconductor device according to claim 11, further comprising an isolation region (30c) provided between the transistor region (30a) and the diode region (30b), wherein
the second lifetime control region (42) is provided in an upper portion of a boundary portion between the transistor region (30a) and the isolation region (30c).

14. The semiconductor device according to any one of claims 11 to 13, wherein the semiconductor portion (30) comprises an n-type first semiconductor region (34) provided with the first lifetime control region (41) and the second lifetime control region (42).

15. The semiconductor device according to claim 14, wherein
the semiconductor portion (30) further comprises:
an n-type second semiconductor region (33) provided below the first semiconductor region (34);
a p-type third semiconductor region (31) provided below the second semiconductor region (33) in the transistor region (30a); and
an n-type fourth semiconductor region (32) provided below the second semiconductor region (33) in the diode region (30b).

16. The semiconductor device according to any one of claims 11 to 15, wherein an IGBT (Insulated Gate Bipolar Transistor) is provided in the transistor region (30a) and an FWD (Free Wheeling Diode) is provided in the diode region (30b).
